# EUROPÄISCHE PATENTSCHRIFT

(11) **EP 1 230 107 B1**
(45) Veröffentlichungstag und Bekanntmachung des Hinweises auf die Patenterteilung: **24.01.2007**
(21) Anmeldenummer: 00987161.7
(22) Anmeldetag: 16.11.2000
(51) Int. Cl.: B60R 16/02

(54) **STEUERGERÄT FÜR EIN KRAFTFAHRZEUG**
CONTROL DEVICE FOR A MOTOR VEHICLE
DISPOSITIF DE COMMANDE POUR VEHICULE AUTOMOBILE

(30) Priorität: 18.11.1999 DE 19955603
(43) Veröffentlichungstag der Anmeldung: 14.08.2002
(73) Patentinhaber: SIEMENS AKTIENGESELLSCHAFT, 80333 München (DE)
(72) Erfinder: SMIRRA, Karl, 83512 Wasserburg (DE); ALBERT, Roland, 93047 Regensburg (DE)
(86) Internationale Anmeldenummer: PCT/DE2000/004069
(87) Internationale Veröffentlichungsnummer: WO 2001/036231

(56) Entgegenhaltungen:
- EP-B- 0 695 117
- WO-A-00/50263
- DE-A- 19 717 348
- DE-A- 19 817 198
- DE-C- 4 023 319
- DE-C- 19 712 842
- DE-C- 19 751 095
- DE-C- 19 826 588
- US-A- 5 452 948
- US-A- 5 941 282

## Beschreibung

Die Erfindung betrifft ein Steuergerät für ein Kraftfahrzeug, insbesondere ein in das Gehäuse eines Automatikgetriebes integriertes Steuergerät, mit einem Komponententräger und einem abgedichtetem Gehäuse für eine Steuerelektronik.

Ein derartiges, den Merkmalen des Oberbegriffs des Anspruchs 1 entsprechendes Steuergerät ist aus der DE 198 17 198 A1 bekannt.

Aus der Patentschrift DE 197 12 842 C1 ist ein in das Gehäuse eines Automatikgetriebes integriertes Steuergerät bekannt.
Ein Gehäusedeckel, der eine Steuerelektronik abdichtet, ist einstückig mit einem Tragkörper ausgebildet. An dem Tragkörper sind elektrische Komponenten angebracht. Aus dem Tragkörper ragen die Enden von Leitern hervor, die zur Herstellung einer elektrischen Verbindung mit einer flexiblen Leiterplatte in Buchsen einer Bodenplatte gesteckt sind. Dabei müssen verhältnismäßig enge Toleranzen eingehalten werden. Zudem besteht eine gewisse Gefahr, daß beim Einstecken der Leiterenden Leiterbahnen der flexiblen Leiterplatte abgerissen werden.

Aus der Patentschrift DE 197 51 095 C1 ist eine elektrische Verbindungsanordnung bekannt, bei der auf die Kontakte zwischen den Leitern im Tragkörper und der flexiblen Leiterplatte verzichtet werden kann, wenn die flexible Leiterplatte durch das abgedichtete Gehäuse des Steuergeräts hindurch bis zu den elektrischen Komponenten geführt wird. Allerdings ist das Leiterplattenmaterial verhältnismäßig teuer. Wegen der regelmäßig aus Kostengründen nur einseitigen Kontaktierbarkeit der flexiblen Leiterplatte, muß letztere teilweise gefaltet, gedreht und geknickt werden. Dabei entsteht ein erheblicher Montageaufwand und Materialverbrauch durch das Falten.

In der Patentschrift EP 0 695 117 B1 ist ein Steuergerät mit einem Kunststoffgehäuse gezeigt, in dem Stanzgitter eingegossen sind. Im Inneren des Gehäuses sind elektronische Baugruppen mit den Stanzgittern kontaktiert. Es ist jedoch sehr schwierig, bei durch Stanzgitter realisierten Gehäusedurchführungen eine absolute Dichtigkeit gegenüber Medien wie Getriebeöl zu erzielen.

In der Patentschrift DE 40 23 319 C1 ist ein Steuergerät beschrieben, das eine wärmeleitende Platte mit einer flexiblen Leiterplatte aufweist, auf der elektrische Komponenten angeordnet sind. Elektrische Komponenten sind durch haubenartige Deckel geschützt. Ferner ist auf der Oberseite der Platte eine Steckerleiste mit Anschlusskontakten angeordnet. Durch eine Öffnung der Platte ragen Anschlussdrähte der Steckerleiste in die flexible Leiterplatte.

Es ist ein Ziel der Erfindung, ein Steuergerät für ein Kraftfahrzeug bereit zu stellen, das eine kostengünstige Herstellung und eine zuverlässige, vibrationsbeständige, hermetisch dichte elektrische Verbindung zwischen einer Steuerschaltung und hiervon entfernt angeordneten elektrischen Komponenten ermöglichen.

Dieses Ziel wird mit einem Steuergerät erreicht, wie es in dem unabhängigen Patentanspruch definiert ist.

Erfindungsgemäß stellt die flexible Leiterplatte eine elektrische Verbindung zwischen der im abgedichteten Gehäuse angeordneten Steuerschaltung und in den Leitungsträger integrierten oder eingebetteten Leitern her. Der separate Leitungsträger läßt sich mit dem Komponententräger derart mechanisch verbinden, daß die flexible Leiterplatte oder Folie zur Auflage auf dem Leitungsträger kommt. Dort kann eine spannungsfreie und vibrationsbeständige elektrische Verbindung zwischen den Leitern und Leiterbahnen der flexiblen Leiterplatte, beispielsweise durch Löten, Bonden oder vorzugsweise Schweißen, hergestellt werden.

Als kostengünstige Leiter eignen sich metallische Objekte wie Drähte, Metallstreifen oder Stanzgitter, die vorzugsweise in den Leitungsträger eingespritzt, eingepreßt oder in eine Nut eingepaßt werden. Ferner können die Leiter durch MID-Technologie realsiert werden, d.h. durch metallisierte Kunststoffoberflächen.

In einer besonders bevorzugten Ausführungsform der Erfindung ist der Leitungsträger spielbehaftet am Komponententräger angebracht. Die flexiblen Eigenschaften der flexiblen Leiterplatte lassen ein Spiel zwischen dem Leitungsträger und dem Komponententräger zu, ohne daß die elektrischen Kontaktstellen zwischen der flexiblen Leiterplatte und den Leitern einer unzulässigen Belastung ausgesetzt werden. Das vorgesehene Spiel zwischen dem Komponententräger und dem Leitungsträger ermöglicht die einfache und exakte Einpassung einer oder mehrerer Komponenten des Leitungsträgers in einen Einbauort.

Dabei ist es besonders vorteilhaft, wenn der Leitungsträger einen abtrennbaren Abschnitt aufweist, auf dem ein Steckverbinder angeordnet ist. Dadurch wird die Beweglichkeit des den Steckverbinder tragenden Abschnitts deutlich verbessert. Die trennbare Verbindung zwischen den Abschnitten kann linien- oder punktförmig ausgeführt sein. Bei einer trennbaren punktförmigen Verbindung mit einer gewissen Distanz der restlichen Konturen der Abschnitte voneinander, können sich die Abschnitte bei einer Relativbewegung gegeneinander nicht gegenseitig hemmen oder aneinander reiben.

Vorzugsweise ist die flexible Leiterplatte eine flexible Folie (Flexfolie) mit Leiterbahnen aus Kupfer und diese abdeckende Polyimidschichten.

Bei der Herstellung des Steuergeräts wird in den Körper des Leitungsträgers ein metallischer Leiter integriert oder aufgenommen. Mit Hilfe des Leitungsträgers können elektrische Verbindungen auf einfache Weise zwischen der flexiblen Leiterplatte, die zur dichten Gehäusedurchführung benötigt wird, und entfernt angeordneten elektrischen Komponenten hergestellt werden. Dabei können die elektrischen Komponenten auf dem Leitungsträger und/oder auf dem Komponententräger angeordnet sein.

Ein besonders bevorzugter Anwendungsfall der Erfindung besteht in einem Getriebesteuergerät, das vollständig in das mit Öl befüllte Gehäuse eines Automatikgetriebes integriert ist.

Weitere Merkmale, Vorteile und Anwendungsmöglichkeiten der Erfindung ergeben sich aus der Beschreibung eines Ausführungsbeispiels in Verbindung mit den Zeichnungen. Es zeigen:
- Figur 1: eine perspektivische Ansicht eines Getriebesteuergeräts,
- Figur 2: die Rückseite des Getriebesteuergeräts,
- Figur 3: den Komponententräger des Steuergeräts,
- Figur 4: den Leitungsträger des Steuergeräts, und
- Figur 5: eine Teilansicht eines Schnitts durch das Getriebesteuergerät.

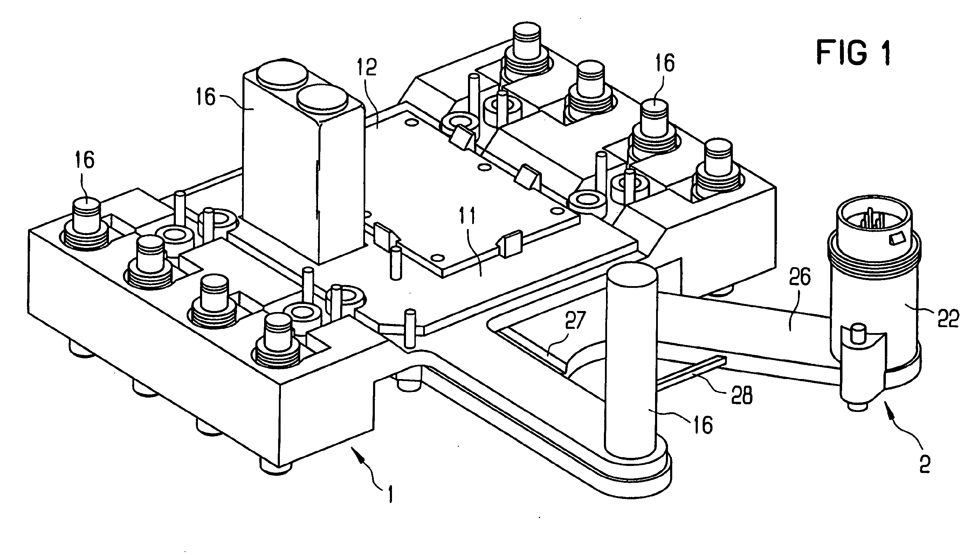

Figur 1 veranschaulicht ein Getriebesteuergerät, das für den Einbau in das mit Öl befüllte Gehäuse eines Automatikgetriebes eines Kraftfahrzeugs bestimmt ist.

Aus einem Gehäuse 12, 15 heraus erstreckt sich auf einen Komponententräger 1 eine flexible Leiterplatte 11 oder Flexfolie. Das Gehäuse 12, 15 wird durch eine Kühlplatte 12 hermetisch dicht gegenüber Getriebeöl abgedichtet. Die flexible Leiterplatte 11 ist auf die Kühlplatte 12 laminiert. Auf dem Komponententräger 1 sind elektrische Komponenten 16 angeordnet. Dabei handelt es sich um Magnetventile, und zwei Drehzahlsensoren.

Ein Leitungsträger 2 aus Kunststoff ist an der Unterseite des Komponententrägers 1 befestigt. Der Leitungsträger 2 weist an seinem vom Komponententräger 1 entfernten Ende einen Steckverbinder 22 oder Stecker als elektrische Komponente auf. Der Steckverbinder 22 wird dicht in eine entsprechende Öffnung des Getriebegehäuses eingesetzt, um eine Verbindung zu einem fahrzeuginternen Datenbus und zu einer Energieversorgung herzustellen. Das Gehäuse des Steckverbinders 22 ist einstückig mit dem Leitungsträger 2 hergestellt. Die flexible Leiterplatte liegt mit ihrer der Kühlplatte 12 abgewandten Seite sowohl auf dem Komponententräger 1 als auch auf dem Leitungsträger 2 auf.

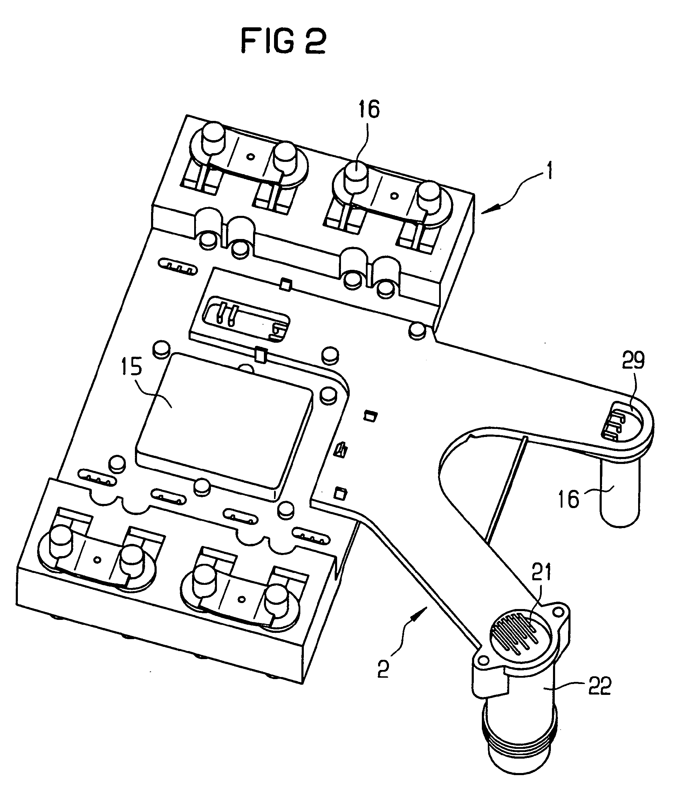

Figur 2 zeigt die Unterseite des Steuergeräts. Der Leitungsträger 2 ist in der Nachbarschaft einer Gehäusewanne 15, die eine elektronische Steuerschaltung 13 aufnimmt, in den Komponententräger 1 eingefügt und verrastet. Der Leitungsträger 2 ist von der Seite in den Komponententräger 1 eingefügt, die der flexiblen Leiterplatte 11 abgewandt ist.

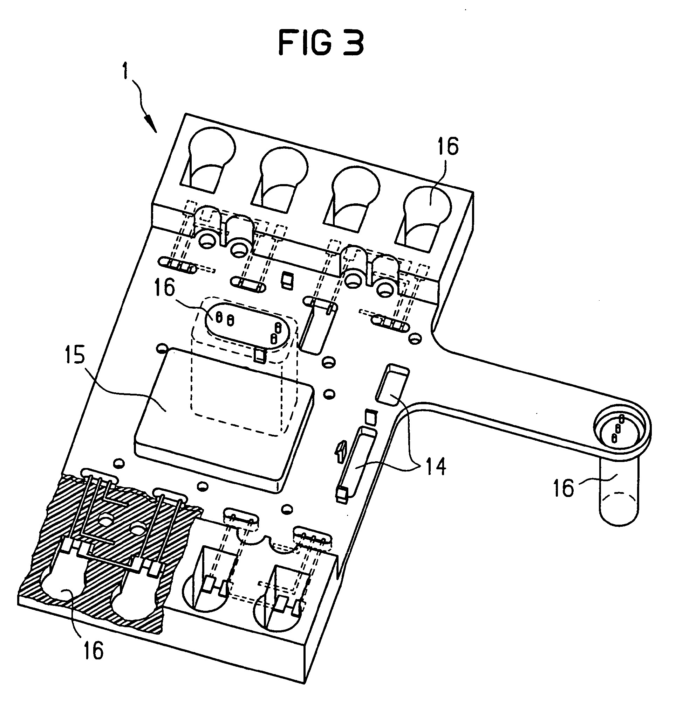

Figur 3 stellt den Komponententräger 1 vor dem Hinzufügen des Leitungsträgers 2 dar. Im Komponententräger 1 sind Ausnehmungen 14 vorhanden, in die ein mit elektrischen Kontakten versehener Steg des Leitungsträgers eingesetzt werden kann. Die Ausnehmungen 14 sind außerhalb des durch die Gehäusewanne 15 und die Kühlplatte 12 gebildeten Gehäuses 12, 15.

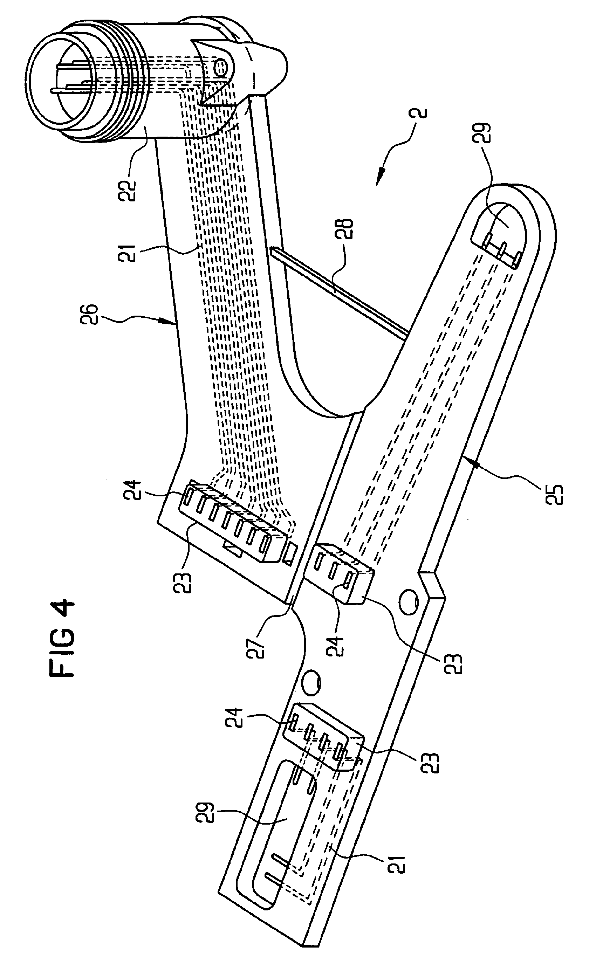

Figur 4 veranschaulicht den Leitungsträger 2 mit den Leitern 21 in Form von gestanzten Blechstreifen oder Stanzgittern. Die Leiter 21 sind von Kunststoffmaterial des Leitungsträgers umspritzt. Die Leiter 21 bilden auf den Kontaktblöcken oder Stegen 23 Kontakte 24 aus, mit denen entsprechende Kontaktstellen oder Leiterbahnen der flexiblen Leiterplatte 11 elektrisch kontaktiert werden.

Die Stege ragen so weit gegenüber der Auflagefläche des Leitungsträgers 2 auf dem Komponententräger 1 hervor, daß die in die Ausnehmungen 14 eingeführten Stege 23 mit der als Leiterbahnauflage dienenden Fläche des Komponententrägers 1 bündig abschließen. Die Leiter 21 erstrecken sich von den Stegen 23 zu elektrischen Komponenten, nämlich zu den Kontaktstiften des Steckverbinders 22 des Leitungsträgers 2 und zu den Drehzahlsensoren, die auf dem Komponententräger 1 angeordnet sind.

Der Leitungsträger 2 wird als ein integrales Teil hergestellt und verbaut. Nach dem Befestigen des Leitungsträgers 2 am Komponententräger 1 ist allerdings eine gewisse Beweglichkeit des Abschnitts 26 erwünscht, damit der Steckverbinder 22 leichter in eine Gehäuseöffnung des Getriebes eingepaßt werden kann. Hierzu kann der Komponententräger 1 entlang eines geschwächten Abschnitts oder einer Nut 27 aufgetrennt und von einem Verbindungssteg 28 befreit werden. Die Nut 27 stellt eine Sollbruchstelle dar. Dadurch entstehen zwei voneinander getrennte Abschnitte 25 und 26. Somit vereint der Leitungsträger 2 die Vorteile einer kostengünstigen Fertigung und Montage sowie einer vereinfachten Logistik mit den Vorteilen an Beweglichkeit, die eine zweiteilige Ausgestaltung des Leitungsträgers 2 mit sich bringt.

Jeder der beiden Abschnitte 25 und 26 weist jeweils eine mechanische Verbindung zum Komponententräger 1 und eine elektrische Verbindung zwischen den Leitern 21 und Leiterbahnen der flexiblen Leiterplatte 11 auf. Die mechanische und die elektrische Verbindung zwischen dem Komponententräger 1 und dem Leitungsträger 2, beziehungsweise den Abschnitten 25 und 26, sind voneinander mechanisch entkoppelt.

In den Bereichen des Leitungsträgers 2, an denen die elektrischen Komponenten vorgesehen sind, befinden sich Aussparungen oder Öffnungen 29. In diese Öffnungen erstrecken sich die Leiter 21. Durch die Öffnungen 29 sind die Kontaktstellen zwischen den Leitern 21und den Anschlüssen der elektrischen Komponenten von außen für die Kontaktierung zugänglich. Die elektrischen Verbindungen zwischen den Leitern 21 und den elektrischen Komponenten einerseits und der flexiblen Leiterplatte 11 andererseits können in einem Prozeßschritt nach dem Befestigen des Leitungsträgers 2 am Komponententräger 1 hergestellt werden. Hierzu eignet sich besonders das Laserschweißen.

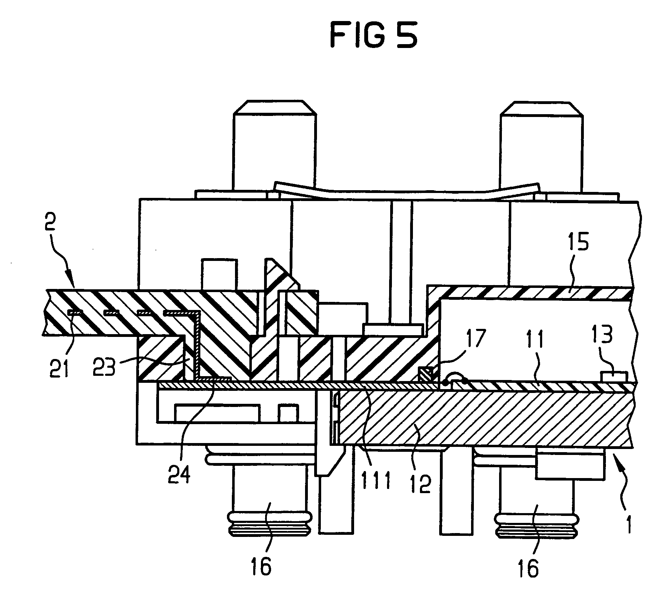

Figur 5 zeigt den Komponententräger 1, an dem der Leitungsträger 2 spielbehaftet verrastet ist. Dabei kann ein Spiel zwischen 1 mm und 5 mm vorgesehen sein. Dieses ermöglicht eine Längs- und Querbewegung des Leitungsträgers 2 oder eines seiner Abschnitte gegenüber der Ebene der flexiblen Leiterplatte 11 oder gegenüber dem Komponententräger 1. Der Steckverbinder 22 des Steuergeräts kann aufgrund der Beweglichkeit des Leitungsträgers 2 exakt und abgedichtet in eine Öffnung der Wand des Getriebegehäuses eingesetzt werden. Eine unzulässige Belastung der Kontaktstellen zwischen der flexiblen Leiterplatte 11 und den Leitern 21 wird vermieden, da die Kontaktstellen auf dem Leitungsträger 2 angeordnet sind. Die flexible Leiterplatte 11 ist mit Ausnahme der elektrischen Kontakte im Bereich des Leitungsträgers 2 lose mit einem geringem Materialüberschuß angeordnet. Dadurch ist sie gegenüber einer Zug- oder Schubbelastung unempfindlich. Zusätzlich kann eine Zugentlastung vorgesehen sein. Diese kann durch Stifte des Stegs realisiert sein, die die flexible Leiterplatte 11 fixieren.

In dem aus der Gehäusewanne 15 und der Kühlplatte 12 gebildeten Gehäuse 12, 15 ist eine Steuerschaltung 13 auf einem Keramiksubstrat angeordnet. Leiterbahnen des Keramiksubstrats sind mit Leiterbahnen der flexiblen Leiterplatte 11 elektrisch kontaktiert. Die flexible Leiterplatte 11 ist unter Vermittlung einer Dichtung 17 dicht vom Inneren des Gehäuses 12, 15 nach außen geführt. Dort kontaktieren Leiterbahnen der Leiterplatte 11 die Kontakte 24, die auf Stegen 23 des Leitungsträgers 2 angeordnet sind. Die Leiter 21 sind zu den elektrischen Komponenten 16 geführt. Auf diese Weise wird eine elektrische Verbindung zwischen der Steuerschaltung 13 und den elektrischen Komponenten 16 hergestellt.

## Patentansprüche

1. Steuergerät für ein Kraftfahrzeug, insbesondere ein in das Gehäuse eines Automatikgetriebes integriertes Steuergerät, das aufweist:
- einen Komponententräger (1) mit einem abgedichteten Gehäuse (12,15), in welchem eine elektronische Steuerschaltung (13) angeordnet ist, wobei auf dem Komponententräger (1) mindestens eine elektrische Komponente (16) angeordnet ist,
- einen am Komponententräger (1) befestigten Leistungsträger (2) aus Kunststoff mit integrierten elektrischen Leitern (21), sowie
- eine flexible Leiterplatte (11), die durch das abgedichtete Gehäuse (12, 15) geführt ist,
**dadurch gekennzeichnet,**
**dass** die flexible Leiterplatte (11) sowohl auf dem Komponententräger (1) als auch auf dem Leitungsträger (2) mit der gleichen Seite aufliegt und dass die elektrische Komponente (16, 22) über die elektrischen Leiter (21) und die flexible Leiterplatte (11) elektrisch mit der Steuerschaltung (13) verbunden ist, wobei der Leitungsträger (2) und der Komponententräger (1) separate Teile sind.

2. Steuergerät nach Anspruch 1, **dadurch gekennzeichnet, daß** der Leitungsträger (2) mit dem Komponententräger (1) spielbehaftet mechanisch verbunden ist.

3. Steuergerät nach dem vorhergehenden Anspruch, **dadurch gekennzeichnet, daß** der Leitungsträger (2) derart an dem Komponententräger (1) befestigt ist, daß der Leitungsträger (2) gegenüber der Ebene der flexiblen Leiterplatte (11) längs und quer bewegbar ist.

4. Steuergerät nach einem der vorhergehenden Ansprüche, **dadurch gekennzeichnet, daß** der Leitungsträger (2) von der Seite in den Komponententräger (1) eingefügt ist, die der flexiblen Leiterplatte (11) abgewandt ist.

5. Steuergerät nach dem vorhergehenden Anspruch, **dadurch gekennzeichnet, daß** der Leitungsträger (2) einen Steg (23) mit Kontakten (24) aufweist, der in einer Ausnehmung (14) des Komponententrägers (1) außerhalb des Gehäuses (12, 15) angeordnet ist.

6. Steuergerät nach einem der vorhergehenden Ansprüche, **dadurch gekennzeichnet, daß** Leiterbahnen der flexiblen Leiterplatte (11) mit den Leitern (21) auf dem Leitungsträger (2) durch eine Schweißverbindung elektrisch kontaktiert sind.

7. Steuergerät nach einem der vorhergehenden Ansprüche, **dadurch gekennzeichnet, daß** der Leitungsträger (2) einstückig hergestellt ist, daß der Leitungsträger (2) mindestens zwei voneinander wenigstens teilweise trennbare und gegeneinander bewegbare Abschnitte (25; 26) aufweist.

8. Steuergerät nach dem vorhergehenden Anspruch, **dadurch gekennzeichnet, daß** jeder Abschnitt (25; 26) eine mechanische Verbindung zum Komponententräger (1) und eine elektrische Verbindung zwischen den Leitern (21) und der flexiblen Leiterplatte (11) aufweist.

9. Steuergerät nach einem der vorhergehenden Ansprüche, **dadurch gekennzeichnet, daß** die Leiter (21) gestanzte Blechstreifen sind, und daß die Blechstreifen vom Kunststoff des Leitungsträgers (2) umspritzt sind.

10. Steuergerät nach einem der vorhergehenden Ansprüche, **dadurch gekennzeichnet, daß** die elektrische Komponente (16) auf dem Komponententräger (1) befestigt ist, und daß ein Teil der elektrischen Verbindungen zwischen der Komponente (16) und der Steuerschaltung (13) auf dem Leitungsträger (2) geführt ist.

## Claims

1. Controller for a motor vehicle, in particular a controller which is integrated into the housing of an automatic transmission, having:
- a component support (1) having a sealed housing (12, 15), in which an electronic control circuit (13) is arranged, wherein at least one electrical component (16) is arranged on the component support (1),
- a conductor support (2) made of plastic with integrated electrical conductors (21) and attached to the component support (1),
- a flexible printed circuit board (11) which is led through the sealed housing (12, 15),
**characterized in that** the flexible printed circuit board (11) rests with the same side on the component support (1) and on the conductor support (2), and **in that** the electrical component (16, 22) is electrically connected to the control ciruict (13) via the electrical conductors (21) and the flexible printed circuit board (11), the conductor support (2) and the component support (1) being separate parts.

2. Controller according to Claim 1, **characterized in that** the conductor support (2) is mechanically connected with play to the component support (1).

3. Controller according to the preceding claim, **characterized in that** the conductor support (2) is attached to the component support (1) in such a way that the conductor support (2) can be moved longitudinally and transversely with respect to the plane of the flexible printed circuit board (11).

4. Controller according to one of the preceding claims, **characterized in that** the conductor support (2) is inserted into the component support (1) from the side which faces away from the flexible printed circuit board (11).

5. Controller according to the preceding claim, **characterized in that** the conductor support (2) has a web (23) which has contacts (24) and is arranged in a recess (14) in the component support (1) outside the housing (12, 15).

6. Controller according to one of the preceding claims, **characterized in that** electrical contact is made between the conductor tracks of the flexible printed circuit board (11) and the conductors (21) on the conductor support (2) by means of a welded connection.

7. Controller according to one of the preceding claims, **characterized in that** the conductor support (2) is manufactured in one piece, **in that** the conductor support (2) has at least two sections (25; 26) which can be at least partially separated from one another and can move with respect to one another.

8. Controller according to the preceding claim, **characterized in that** each section (25; 26) has a mechanical connection to the component support (1), and an electrical connection between the conductors (21) and the flexible printed circuit board (11).

9. Controller according to one of the preceding claims, **characterized in that** the conductors (21) are punched strips of sheet metal, and **in that** the strips of sheet metal are encapsulated by injection moulding with the plastic or the conductor support (2).

10. The controller according to one of the preceding claims, **characterized in that** the electrical component (16) is attached to the component support (1), and **in that** part of the electrical connection between the component (16) and the control circuit (13) is led to the conductor support (2).

## Revendications

1. Dispositif de commande pour un véhicule automobile, en particulier un dispositif de commande intégré dans le boîtier d'une transmission automatique, comprenant:
un support de composants (1) avec un boîtier étanche (12, 15), dans lequel on dispose un circuit de commande (13) électronique, au moins un composant électrique (16) étant disposé sur le support de composants (1),
un porte-conducteur (2) en matière plastique fixé au support de composants (1) avec des conducteurs (21) électriques intégrés, ainsi qu'
une carte de circuits imprimés (11) flexible qui traverse le boîtier étanche (12, 15),
**caractérisé en ce que**
la carte de circuits imprimés (11) flexible est posée du même côté aussi bien sur le support de composants (1) que sur le porte-conducteur (2) et que le composant électrique (16, 22) est relié électriquement, via les conducteurs électriques (21) et la carte de circuits imprimés flexible (11), avec le circuit de commande (13), le porte-conducteur (2) et le support de composants (1) étant des pièces séparées.

2. Dispositif de commande selon la revendication 1, **caractérisé en ce que** le porte-conducteur (2) et le support de composants (1) sont raccordés mécaniquement avec jeu.

3. Dispositif de commande selon la revendication précédente, **caractérisé en ce que** le porte-conducteur (2) est fixé au support de composants (1) de telle façon que le porte-conducteur (2) peut être déplacé dans le sens de la longueur et dans le sens de la largeur par rapport au plan de la carte de circuits imprimés flexible (11).

4. Dispositif de commande selon l'une quelconque des revendications précédentes, **caractérisé en ce que** le porte-conducteur (2) est introduit dans le support de composants (1) par le côté qui est opposé à la carte de circuits imprimés flexible (11).

5. Dispositif de commande selon la revendication précédente, **caractérisé en ce que** le porte-conducteur (2) comprend une barrette (23) avec des contacts (24) qui est disposée à l'extérieur du boîtier (12, 15) dans un évidement (14) du support de composants (1).

6. Dispositif de commande selon l'une quelconque des revendications précédentes, **caractérisé en ce que** des pistes conductrices de la carte de circuits imprimés (11) flexible sont mises en contact électrique avec les conducteurs (21) du porte-conducteur (2) par un assemblage par soudure.

7. Dispositif de commande selon l'une quelconque des revendications précédentes, **caractérisé en ce que** le porte-conducteur (2) est fabriqué en une seule pièce, que le porte-conducteur (2) comprend au moins deux sections (25 ; 26) séparables l'une de l'autre au moins en partie et mobiles l'une par rapport à l'autre.

8. Dispositif de commande selon la revendication précédente, **caractérisé en ce que** chaque section (25 ; 26) comprend une liaison mécanique avec le support de composants (1) et une liaison électrique entre les conducteurs (21) et la carte de circuits imprimés (11) flexible.

9. Dispositif de commande selon l'une quelconque des revendications précédentes, **caractérisé en ce que** les conducteurs (21) sont des bandes de jonction estampées et que les bandes de jonction sont enrobées par la matière plastique du porte-conducteur (2).

10. Dispositif de commande selon l'une quelconque des revendications précédentes, **caractérisé en ce que** le composant électrique (16) est fixé sur le support de composants (1) et qu'une partie des liaisons électriques entre le composant (16) et le circuit de commande (13) est réalisée sur le porte-conducteur (2).
